# EUROPEAN PATENT APPLICATION

(11) **EP 4 641 629 A1**
(43) Date of publication of application: **29.10.2025**
(21) Application number: 23907209.3
(22) Date of filing: 22.12.2023
(51) Int. Cl.: H01L 23/12, H01L 23/02, H01L 23/04, H01L 23/13, H01L 31/02, H01S 5/0231

(54) **WIRING BOARD, ELECTRONIC COMPONENT MOUNTING BOARD USING WIRING BOARD, AND ELECTRONIC MODULE**

(30) Priority: 23.12.2022 JP 2022206872
(71) Applicant: Kyocera Corporation, Kyoto-shi, Kyoto 612-8501 (JP)
(72) Inventor: SUGIMOTO Yoshimasa, Kyoto-shi, Kyoto 612-8501 (JP); KON Tomoya, Kyoto-shi, Kyoto 612-8501 (JP)
(74) Representative: Viering, Jentschura & Partner mbB Patent- und Rechtsanwälte
(86) International application number: PCT/JP2023/046265
(87) International publication number: WO 2024/135849

(57) **Abstract**

A wiring board includes a substrate, a conductor portion, and a terminal portion. The substrate includes a first surface and a first opening. The conductor portion includes a first conductor and a second conductor, and is positioned on the first surface. The terminal portion includes a first pin terminal and a second pin terminal. The second conductor is positioned to be spaced apart from the first conductor in a first direction. The first pin terminal is connected to the first conductor and extends upward. The second pin terminal is connected to the second conductor and extends upward. The first opening is positioned to be spaced apart from the first conductor, the second conductor, and a first imaginary line in a second direction perpendicular to the first direction. The first opening is positioned on a second imaginary line.

## Description

### TECHNICAL FIELD

The present disclosure relates to a wiring board, an electronic component mounting substrate including the wiring board, and an electronic module.

### BACKGROUND OF INVENTION

Patent Literature 1 and the like describe a wiring board according to a conventional technique (see Patent Literature 1).

### CITATION LIST

### PATENT LITERATURE

Patent Literature 1: Japanese Unexamined Patent Application Publication No. 2013-110310

### SUMMARY

In an embodiment, (1) a wiring board includes a substrate, a conductor portion, and a terminal portion. The substrate includes a first surface, and an opening region positioned in the first surface. The conductor portion is positioned on the first surface. The conductor portion includes a first conductor and a second conductor. The terminal portion includes a first pin terminal and a second pin terminal. The opening region includes a first opening. The second conductor is positioned to be spaced apart from the first conductor in a first direction. The first pin terminal is electrically connected to the first conductor. The first pin terminal extends upward from the first surface. The second pin terminal is electrically connected to the second conductor. The second pin terminal extends upward from the first surface. Assuming that a first imaginary line extends in the first direction and passes through the first conductor and the second conductor and a second imaginary line extends in a second direction perpendicular to the first direction and passes through a midpoint in the first direction between the first conductor and the second conductor in a planar view, the first opening is positioned to be spaced apart from the first conductor, the second conductor, and the first imaginary line in the second direction. The first opening is positioned on the second imaginary line.

(2) In the wiring board according to (1) described above, the opening region further includes a second opening. The second opening is positioned opposite to the first opening with the first imaginary line interposed therebetween.

(3) In the wiring board according to (1) or (2) described above, the opening region further includes at least one third opening. The third opening is positioned between the first conductor and the second conductor on the first imaginary line.

(4) In the wiring board according to (3) described above, the third opening connects the first opening and the second opening in a planar view.

(5) In the wiring board according to (3) or (4) described above, the third opening has a size in the first direction on the first imaginary line, and the size is smaller than at least one of a maximum size in the first direction of the first opening or a maximum size in the first direction of the second opening.

(6) In the wiring board according to (2) to (5) described above, the first opening and the second opening each have a circular shape in a planar view.

(7) In the wiring board according to (2) to (6) described above, the at least one third opening has a rectangular shape in a planar view. One of two opposing sides of the third opening is positioned along the second direction in a planar view.

(8) In the wiring board according to (2) to (7) described above, in a planar view, the opening region is shaped to be along an outer edge of the first conductor and is shaped to be along an outer edge of the second conductor.

(9) In the wiring board according to (2) to (8) described above, the opening region is shaped line symmetrically with respect to the first imaginary line in a planar view.

(10) In the wiring board according to (3) to (9) described above, the conductor portion further includes a third conductor and a fourth conductor. The terminal portion further includes a third pin terminal and a fourth pin terminal. The opening region further includes a fourth opening and a fifth opening. The second conductor is positioned to be spaced apart from the first conductor by a first distance in the first direction. The third conductor is positioned to be spaced apart from the first conductor by a second distance in the second direction. The fourth conductor is positioned to be spaced apart from the second conductor by a third distance in the second direction. The third conductor and the fourth conductor are positioned to be spaced apart from each other by a fourth distance in the first direction. The third pin terminal is electrically connected to the third conductor and extends upward from the first surface. The fourth pin terminal is electrically connected to the fourth conductor and extends upward from the first surface. The second distance is equal to the third distance. The first distance is equal to the fourth distance. The first opening is surrounded with the first conductor, the second conductor, the third conductor, and the fourth conductor. The fourth opening is positioned opposite to the second opening with the first opening interposed therebetween. The fifth opening is positioned between the third conductor and the fourth conductor on the second imaginary line, and connects the first opening and the fourth opening.

(11) In the wiring board according to (10) described above, assuming that a third imaginary line passes through the second conductor and the third conductor and the second imaginary line and the third imaginary line cross each other at a first intersection point in a planar view, the opening region is shaped symmetrically with respect to the first intersection point in a planar view.

(12) In the wiring board according to (1) to (11) described above, the substrate includes an outer edge portion in a circular shape in a planar view. A distance between the first conductor and the outer edge portion is shorter than a distance between the second conductor and the outer edge portion. The opening region further includes a sixth opening positioned to be spaced apart from the first conductor and positioned between the outer edge portion and the first conductor in the first direction. The sixth opening has a linear shape along a tangent of the outer edge portion in a planar view.

(13) In the wiring board according to (4) to (12) described above, the opening region further includes a seventh opening positioned to be spaced apart from the first opening and the second opening. The seventh opening is positioned on the first imaginary line. The first conductor is positioned between the seventh opening and the third opening in the first direction.

(14) In the wiring board according to (13) described above, the opening region further includes an eighth opening positioned to be spaced apart from the first opening and the second opening. The eighth opening is positioned on the first imaginary line. The second conductor is positioned between the eighth opening and the third opening in the first direction.

(15) In the wiring board according to (1) to (14) described above, the opening region has a depth smaller than a distance between the first conductor and the second conductor in the first direction.

(16) In an embodiment, an electronic component mounting substrate includes the wiring board according to (1) to (15) described above, and an electronic component connecting electrode positioned on a second surface opposite to the first surface. In the electronic component mounting substrate, the first conductor and the second conductor are electrically connected to the electronic component connecting electrode.

(17) In an embodiment, an electronic module includes the electronic component mounting substrate according to (16) described above, and an electronic component electrically connected to the electronic component connecting electrode.

### BRIEF DESCRIPTION OF THE DRAWINGS

FIG. 1 is a perspective view of a wiring board according to an embodiment.
FIG. 2 is a perspective view from a negative side of a z axis, of a wiring board according to an embodiment.
FIG. 3 is a plan view of a wiring board according to an embodiment.
FIG. 4 is a perspective view of a terminal portion according to an embodiment.
FIG. 5 is a perspective view of a wiring board according to an embodiment, excluding a terminal portion.
FIG. 6 is an enlarged view of a principal part A indicated in FIG. 3.
FIG. 7 is an enlarged view of a principal part B indicated in FIG. 5.
FIG. 8 is an enlarged plan view of a wiring board according to a second embodiment.
FIG. 9 is an enlarged perspective view of a wiring board according to a third embodiment.
FIG. 10 is an enlarged plan view of the wiring board according to the third embodiment.
FIG. 11 is an enlarged plan view of a wiring board according to a variation of the third embodiment.
FIG. 12 is an enlarged plan view of a wiring board according to a fourth embodiment.
FIG. 13 is an enlarged plan view of a wiring board according to a fifth embodiment.

### DESCRIPTION OF EMBODIMENTS

Patent Literature 1 describes a wiring board including a motherboard, a conductor layer provided on the motherboard, and a lead pin bonded to the conductor layer. The conductor layer is electrically connected to an electronic component via a wiring conductor positioned in the motherboard.

In the wiring board thus configured, the motherboard has a high relative dielectric constant to possibly cause an impedance decrease of the conductor layer and the wiring conductor. This may lead to a large loss in radio-frequency signal transmission.

Furthermore, conductor layers need to be positioned closer to each other due to a size reduction of a wiring board. However, when the conductor layers are positioned closer to each other, leakage of a bonding material used to bond the lead pin to one of the conductor layers may connect the conductor layers to cause an electrical short circuit.

### <Configuration of wiring board>

Several exemplary embodiments will be described hereinafter with reference to the drawings. A wiring board may be disposed to include a top or a bottom in any direction. For convenience, the wiring board is defined to have an orthogonal coordinate system xyz, and a positive side in a z direction is assumed to indicate an upper side. In the present disclosure, a planar view conceptually includes a plan perspective view. The present disclosure refers to a first direction exemplarily indicating an x direction in the drawings. A second direction exemplarily indicates a y direction in the drawings. The first direction and the second direction may be opposite to each other at a location. A third direction exemplarily indicates the z direction in the drawings. In the present disclosure, width, length, and thickness can be defined as a size in the x direction, a size in the y direction, and a size in the z direction, respectively.

Described hereinafter are only configurations according to a second embodiment and a third embodiment different from configurations according to each embodiment. The remaining configurations will be denoted by reference signs identically to each embodiment and will not be described repeatedly.

### (First Embodiment)

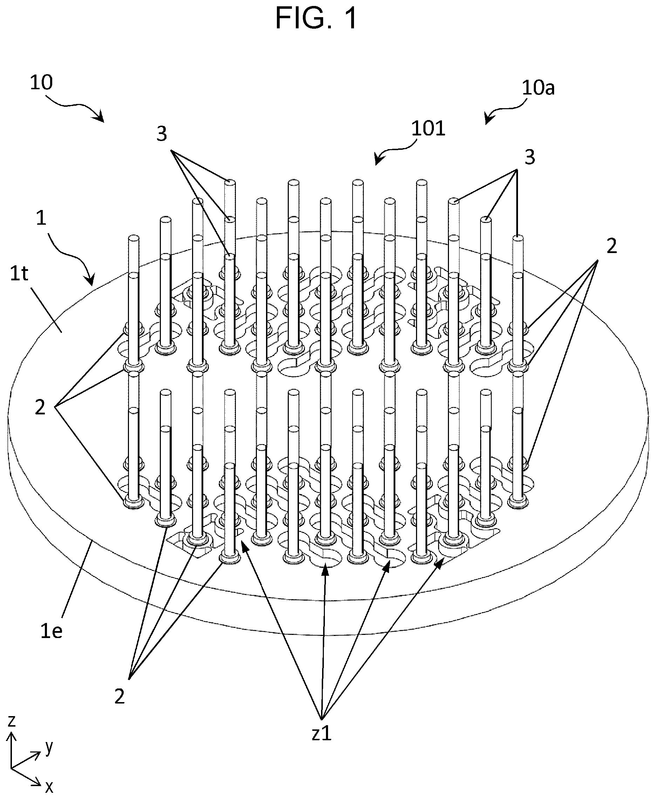

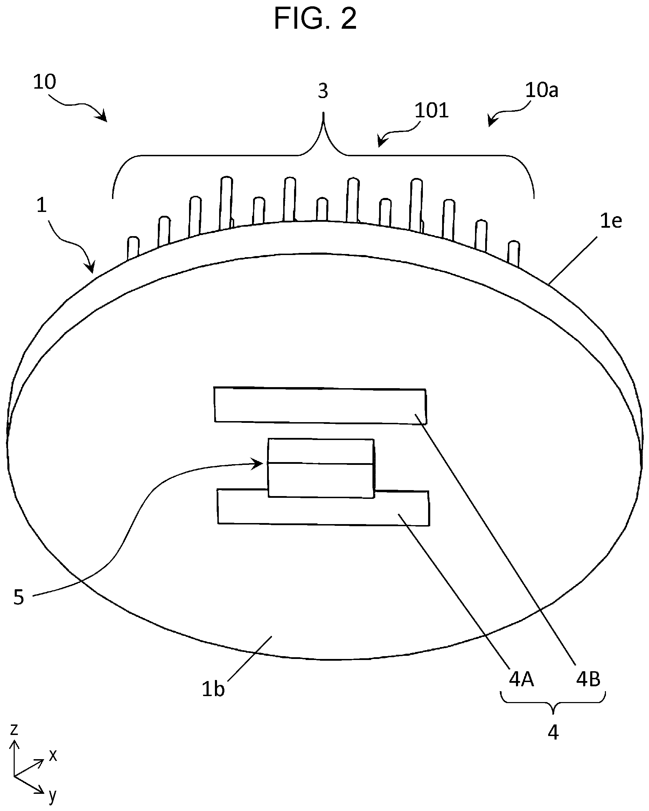

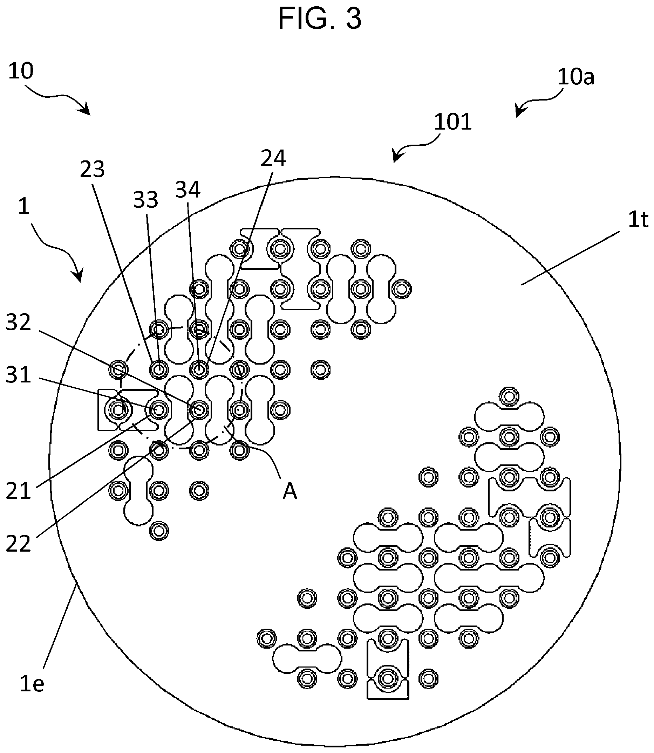

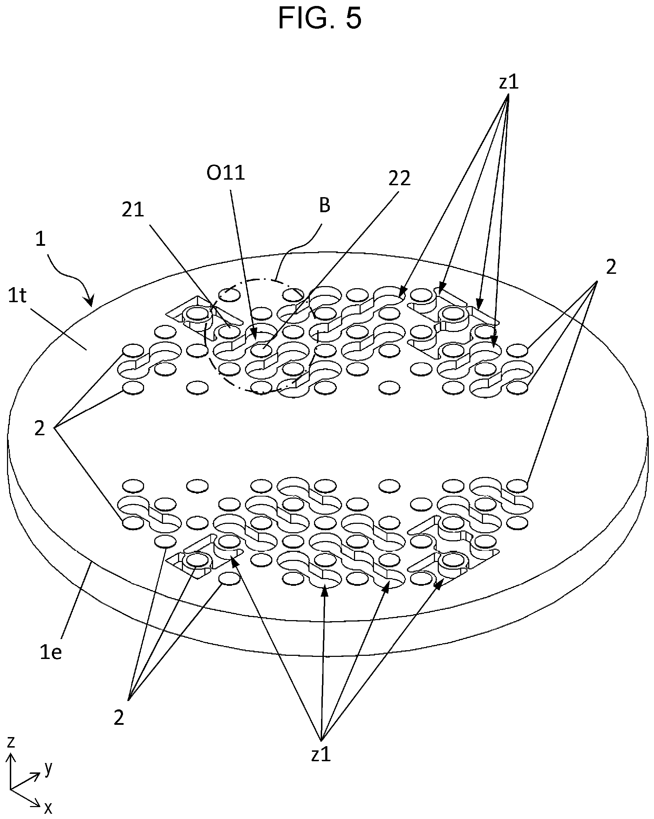

Description is made to a wiring board 101 according to the first embodiment with reference to FIGs. 1 to 7.

The wiring board 101 includes a substrate 1, a conductor portion 2, and a terminal portion 3. Some of the figures do not illustrate the terminal portion 3 (e.g., a first pin terminal 31 or a second pin terminal 32) for convenience.

The substrate 1 includes a first surface 1t and an opening region z1 positioned in the first surface 1t. The substrate 1 may further include a second surface 1b. Examples of a material for the substrate 1 can include dielectric materials including a ceramic material such as an aluminum oxide sintered body, a mullite sintered body, a silicon carbide sintered body, an aluminum nitride sintered body, or a silicon nitride sintered body, a glass ceramic material, and a glass epoxy material.

The substrate 1 may be constituted by a single layer or a plurality of stacked insulating layers. The substrate 1 exemplarily has a circular shape or a rectangular shape in a planar view having 4 mm × 4 mm to 50 mm × 50 mm in size and 0.5 mm to 10 mm in thickness.

The substrate 1 can be manufactured in the following exemplary manner. A plurality of green sheets is processed with use of a die or the like to prepare a plurality of green sheets formed into an outer shape of the substrate 1. Subsequently, the plurality of green sheets is stacked to match outer edges so as to form a green sheet stacked body. The green sheet stacked body is burned to sinter the plurality of green sheets so as to obtain the substrate 1.

The substrate 1 may include a conductor layer disposed inside. The conductor layer may be electrically connected to the conductor portion 2.

The substrate 1 and the conductor portion 2 may alternatively be formed by additive manufacturing (AM) with use of a 3D printer.

The conductor portion 2 is positioned on the first surface 1t. The conductor portion 2 is made of a material, examples of which include metallic materials such as gold, silver, copper, nickel, tungsten, molybdenum, and manganese. The conductor portion 2 may be formed by sintering a metal paste on the substrate 1 in a state of green sheets, or may be formed by applying a thin film forming technique such as an evaporation method or a sputtering method. The conductor portion 2 may be structured by conductors aligned at constant intervals in a lattice shape. Part of the conductor portion 2 may be further provided thereon with an insulating film made of at least one of a ceramic (e.g., alumina coating), a resin, or the like. Parts of conductor portions 2 are not necessarily independent from each other and may be integral with each other.

The conductor portion 2 may include a portion extending toward the inside of the substrate 1. That is, the conductor portion 2 may be electrically conducted with at least one of the inside of the substrate 1 or the second surface 1b by means of a via hole or the like.

The conductor portion 2 includes a first conductor 21 and a second conductor 22. The conductor portion 2 may include either a plurality of first conductors 21 or a plurality of second conductors 22, or both thereof. The second conductor 22 is positioned to be spaced apart from the first conductor 21 in the first direction (in other words, the x direction). When the conductor portion 2 includes either the plurality of first conductors 21 or the plurality of second conductors 22 or both thereof, part of the second conductors 22 may be positioned to be spaced apart from the first conductors 21 in the second direction (in other words, the y direction) perpendicular to the first direction. A distance in the first direction between the second conductor 22 and the first conductor 21 may be defined as a first distance L1. The first distance L1 herein indicates a minimum distance between the first conductor 21 and the second conductor 22.

A solder ball in addition to the terminal portion 3 to be described later may be bonded to the conductor portion 2. The wiring board 101 can be formed as a so-called ball grid array (BGA) in this case.

The first conductor 21 and the second conductor 22 may each have a circular shape or a rectangular shape in a planar view. The first conductor 21 and the second conductor 22 may be shaped identically or differently. At least one of the first conductor 21 or the second conductor 22 may be a signal conductor configured to transmit signals, or both thereof may be signal conductors configured to transmit signals. When both the first conductor 21 and the second conductor 22 are signal conductors, the first conductor 21 and the second conductor 22 may be configured to transmit a pair of differential signals. At least one of the first conductor 21 or the second conductor 22 may be a ground conductor.

The terminal portion 3 includes the first pin terminal 31 and the second pin terminal 32. The terminal portion 3 may include a plurality of first pin terminals 31 and a plurality of second pin terminals 32. The terminal portion 3 may be a member such as a so-called lead terminal or lead pin. The wiring board 101 includes the terminal portion 3 to be formed as a so-called pin grid array (PGA). The terminal portion 3 is bonded to the conductor portion 2 by a bonding material including at least one of brazing filler metal, solder, or the like.

On a side facing the first surface 1t, the terminal portion 3 may be connected to an external substrate such as a flexible substrate (flexible printed circuit (FPC)) or a printed substrate (printed circuit board (PCB)) provided with an electronic circuit.

The terminal portion 3 is made of a material, examples of which include metallic materials such as iron, copper, nickel, chrome, cobalt, molybdenum, and tungsten, and an alloy obtained by combining any of these metallic materials. The terminal portion 3 can be formed by applying a metalworking method such as a metal rolling method or a punching method to an ingot made of such a metallic material. The terminal portion 3 may have a columnar shape or a prismatic shape.

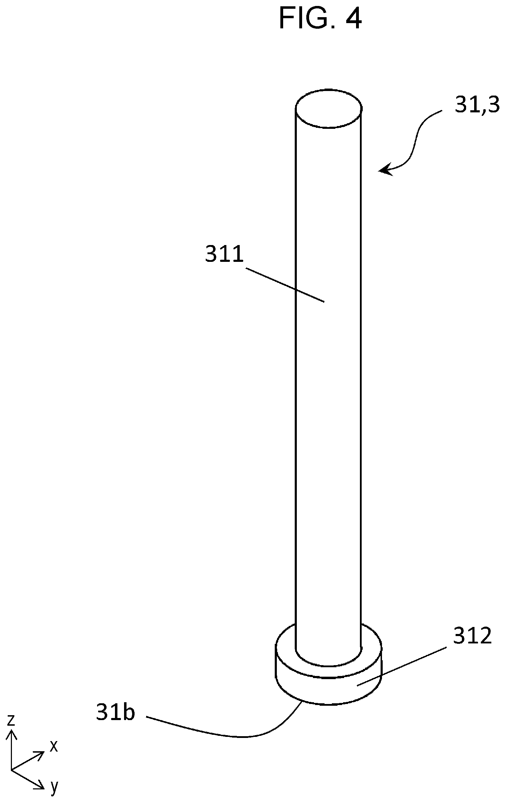

The first pin terminal 31 exemplifying the terminal portion 3 will be described with reference to FIG. 4. The following configuration is applicable as an identical or a similar configuration to the terminal portion 3 other than the first pin terminal 31 (e.g., the second pin terminal 32). The first pin terminal 31 has a columnar shape in an embodiment. The first pin terminal 31 may include a pillar-shaped portion 311 and a seat portion 312. The seat portion 312 may include a bonded surface 31b. The bonded surface 31b can be bonded to the first conductor 21. The bonded surface 31b is not necessarily flat and may exemplarily project to a negative side of a z axis.

The pillar-shaped portion 311 extends in the z direction and is larger in size in the z direction than the seat portion 312. The seat portion 312 is larger in diameter than the pillar-shaped portion 311 in a planar view. The first pin terminal 31 includes the seat portion 312 to have a large area of the bonded surface 31b so as to be mounted stably to the first conductor 21.

When the wiring board 101 is connected to the external substrate, the seat portion 312 is in contact with the external substrate that is thus less likely to be in contact with the first surface 1t. The conductor portion 2 is thus less likely to have variability in impedance value.

The first pin terminal 31 is electrically connected to the first conductor 21. The first pin terminal 31 extends upward from the first surface 1t. The second pin terminal 32 is electrically connected to the second conductor 22. The second pin terminal 32 extends upward from the first surface 1t. Extending upward herein exemplarily means extending in the z direction, and does not necessarily mean extending perpendicularly to the first surface 1t.

The opening region z1 includes a first opening O1. The opening region z1 may be formed by punching the substrate 1 prior to sintering, or may be formed by applying a known piercing process such as drilling, blasting, or laser beam machining to the substrate 1 having been sintered. The opening region z1 does not penetrate the substrate 1 in an embodiment. The opening region z1 may alternatively penetrate the substrate 1.

The first opening O1 has a rectangular shape with rounded corners in a planar view in an embodiment. The first opening O1 may alternatively have a quadrilateral shape or a circular shape such as an elliptical shape in a planar view.

The opening region z1 is filled with a dielectric material containing at least one of air, a resin material, a glass material, or the like, and is lower in dielectric constant than the substrate 1. This enables adjustment of characteristic impedance upon radio-frequency signal transmission to a desired value in at least one of the first conductor 21 or the second conductor 22. This can reduce a loss of signal power generated in at least one of the first conductor 21 or the second conductor 22. The wiring board 101 can thus be configured to transmit a radio-frequency signal more effectively.

The opening region z1 is positioned around the conductor portion 2 so as to retain in the opening region z1 any protruding bonding material used to bond the terminal portion 3. The protruding bonding material is thus less likely to cause an electrical short circuit of the conductor portion 2. Furthermore, the protruding bonding material is kept away from the conductor portion 2 to be less likely to cause variability in impedance value in the conductor portion 2.

Assuming that a first imaginary line T1 extends in the x direction and passes through the first conductor 21 and the second conductor 22 and a second imaginary line T2 extends in the y direction perpendicular to the x direction and passes through a midpoint in the x direction between the first conductor 21 and the second conductor 22 in a planar view, the first opening O1 is positioned to be spaced apart from the first conductor 21, the second conductor 22, and the first imaginary line T1 in the y direction. The first opening O1 is positioned on the second imaginary line T2. This allows the opening region z1 including the first opening O1 to be positioned close to the first conductor 21 and the second conductor 22, as well as can secure a region provided with the first conductor 21 and the second conductor 22.

The first imaginary line T1 can be defined as a line passing through a center in the x direction and the y direction of the first conductor 21 and a center in the x direction and the y direction of the second conductor 22. The first imaginary line T1 may alternatively be defined as a line passing through a center of gravity of the first conductor 21 and a center of gravity of the second conductor 22. The first imaginary line T1 may still alternatively be defined as a line connecting closest points of the first and second conductors 21 and 22.

The opening region z1 may further include a second opening O2. The second opening O2 may be positioned opposite to the first opening O1 with the first imaginary line T1 interposed therebetween. In this case, the first conductor 21 and the second conductor 22 are interposed between the first opening O1 and the second opening O2 in the y direction. The conductor portion 2 is thus less likely to have a decrease in impedance value. The first opening O1 and the second opening O2 are not necessarily connected to each other.

The opening region z1 further includes a third opening O3. The third opening O3 may be positioned between the first conductor 21 and the second conductor 22 on the first imaginary line T1. That is, the third opening O3 is positioned between the first conductor 21 and the second conductor 22 in the x direction. Furthermore, the third opening O3 is positioned between the first opening O1 and the second opening O2 in the y direction. When both the first conductor 21 and the second conductor 22 are signal conductors, a region interposed between the first conductor 21 and the second conductor 22 is thus less likely to be decreased in impedance value.

The third opening O3 may connect the first opening O1 and the second opening O2 in a planar view. When the third opening O3 connects the first opening O1 and the second opening O2, the first opening O1, the second opening O2, and the third opening O3 may be collectively called a first portion O11. When the third opening O3 connects the first opening O1 and the second opening O2, the first portion O11 can be formed collectively to further facilitate manufacture of the wiring board 101. The first portion O11 is positioned between the first conductor 21 and the second conductor 22 to further increase the opening region z1 so as to be less likely to have a decrease in impedance value in at least one of the first conductor 21 or the second conductor 22.

The third opening O3 has a size Lx3 in the x direction on the first imaginary line T1, and the size Lx3 may be smaller than at least one of a maximum size Lx1 in the x direction of the first opening O1 or a maximum size Lx2 in the x direction of the second opening O2. That is, the opening region z1 may be gradually decreased in size from the first opening O1 to the second opening O2, may be gradually increased in size from the first opening O1 to the second opening O2, or may be shaped to be narrow at the third opening O3 positioned between the first opening O1 and the second opening O2. Accordingly, the third opening O3 can be enlarged as much as possible at a location where the first conductor 21 and the second conductor 22 are adjacent to each other (on the first imaginary line T1 in an embodiment), whereas the first opening O1 and the second opening O2 interposing the first conductor 21 and the second conductor 22 in the y direction can be further enlarged. This can reduce the volume of the substrate 1 having a relatively high dielectric constant around the first conductor 21 and the second conductor 22, and the conductor portion 2 is less likely to be decreased in impedance value.

The maximum size Lx1 in the x direction of the first opening O1 may be equal to the maximum size Lx2 in the x direction of the second opening O2.

Furthermore, each of the first opening O1 and the second opening O2 may have a circular shape in a planar view. The first opening O1 having the circular shape herein means at least part of an outer edge of the first opening O1 having a circular shape (i.e., arc shape) in a planar view. Each of the first opening O1 and the second opening O2 does not necessarily have a perfect circular shape. The first opening O1 and the second opening O2 can thus be efficiently positioned close to any other conductor portion 2 (e.g., a third conductor portion 23 or a fourth conductor portion 24 to be described later). The conductor portion 2 is thus effectively less likely to be decreased in impedance value. The first opening O1 and the second opening O2 shaped as described above each include no or fewer corners in comparison to the first opening O1 and the second opening O2 each having a rectangular shape, so that the substrate 1 is less likely to be damaged even when heat or stress is applied to the substrate 1.

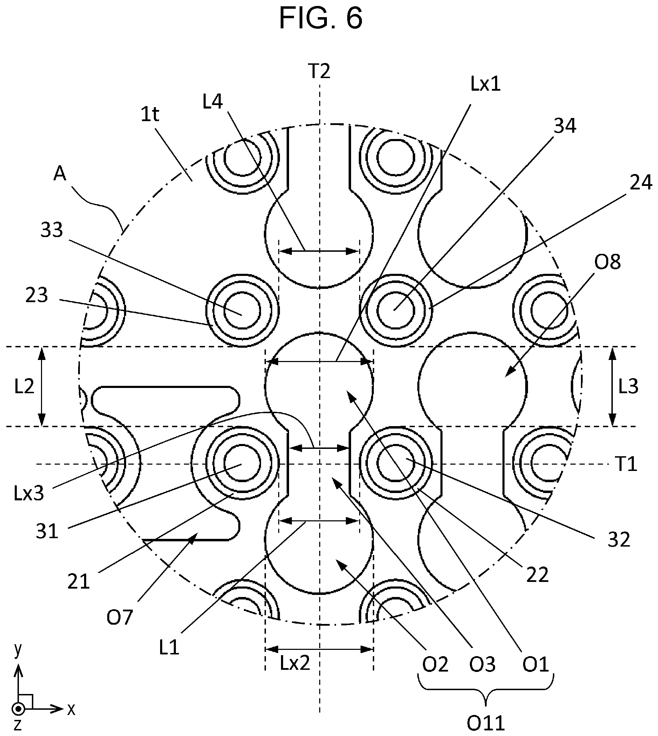

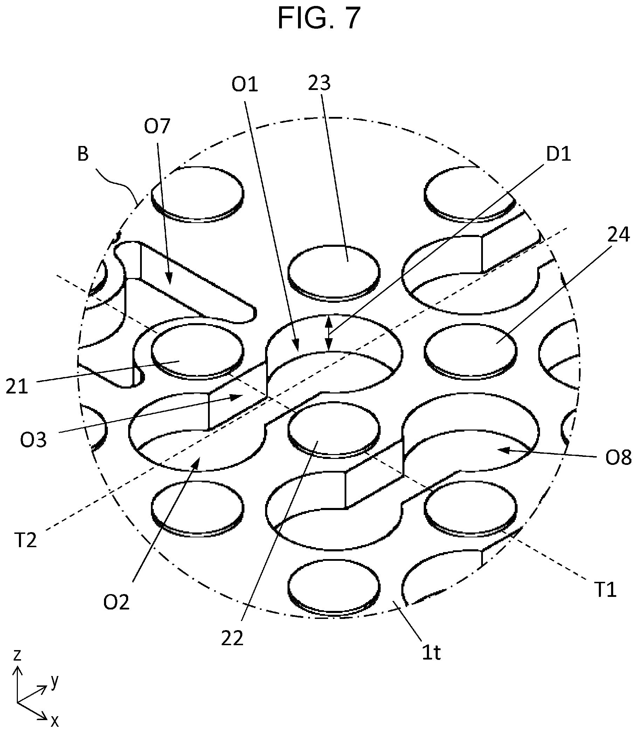

As illustrated in FIGs. 6 and 7, at least one third opening O3 may have a rectangular shape in a planar view. In this case, one of two opposing sides of the third opening O3 may be positioned along the y direction in a planar view. In other words, one of the two opposing sides of the third opening O3 in the rectangular shape may be perpendicular to the first imaginary line T1. The third opening O3 thus has an approximately simple rectangular shape, which facilitates forming the third opening O3 in the substrate 1. Furthermore, a portion between the first conductor 21 and the second conductor 22 is effectively less likely to be decreased in impedance value.

The opening region z1 (more specifically, the first portion O11) may be shaped line symmetrically with respect to the first imaginary line T1 in a planar view. This facilitates equalizing the impedance values of the first conductor 21 and the second conductor 22.

The opening region z1 may further include a seventh opening O7 positioned to be spaced apart from the first opening O1 and the second opening O2. The seventh opening O7 is positioned on the first imaginary line T1. The first conductor 21 is positioned between the seventh opening O7 and the third opening O3 in the x direction. In other words, the first conductor 21 is interposed between the seventh opening O7 and the third opening O3 (more specifically, the first portion O11) in the x direction. When the first conductor 21 is a signal conductor, the substrate 1 positioned around the first conductor 21 can thus be further reduced in volume. The first conductor 21 is thus further less likely to be decreased in impedance value. The first conductor 21 therefore enables radio-frequency signal transmission with a low loss. The seventh opening O7 may be shaped identically to or differently from the first portion O11.

The opening region z1 may further include an eighth opening O8 positioned to be spaced apart from the first opening O1 and the second opening O2. The eighth opening O8 is positioned on the first imaginary line T1. The second conductor 22 is positioned between the eighth opening O8 and the third opening O3 in the x direction. In other words, the second conductor 22 is interposed between the eighth opening O8 and the third opening O3 (more specifically, the first portion O11) in the x direction. When the second conductor 22 is a signal conductor, the substrate 1 positioned around the second conductor 22 can thus be further reduced in volume. The second conductor 22 is thus further less likely to be decreased in impedance value. The second conductor 22 therefore enables radio-frequency signal transmission with a low loss. The eighth opening O8 may be shaped identically to or differently from at least one of the seventh opening O7 or the first portion O11. In other words, the eighth opening O8 and the seventh opening O7 may be shaped line symmetrically to each other with respect to the second imaginary line T2.

As illustrated in FIG. 7, the opening region z1 has a depth D1 that may be smaller than a distance in the x direction between the first conductor 21 and the second conductor 22. The substrate 1 is thus less likely to be decreased in strength. The depth herein means the maximum distance in the z direction from the first surface 1t to a bottom surface of the opening region z1. When the opening region z1 penetrates the substrate 1, the depth D1 of the opening region z1 is equal to the thickness of the substrate 1.

When the opening region z1 does not penetrate the substrate 1, the bottom surface of the opening region z1 is not necessarily flat. That is, the bottom surface of the opening region z1 may be shaped to be stepped in a sectional view. For example, the third opening O3 in the first portion O11 may be further deepened at a position overlapped with the first imaginary line T1 and the second imaginary line T2. The depth D1 of the opening region z1 is not necessarily equal in each opening such as the first opening O1, the second opening O2, or the third opening O3. A conductor may be exposed from at least part of the bottom surface of the opening region z1.

### (Second Embodiment)

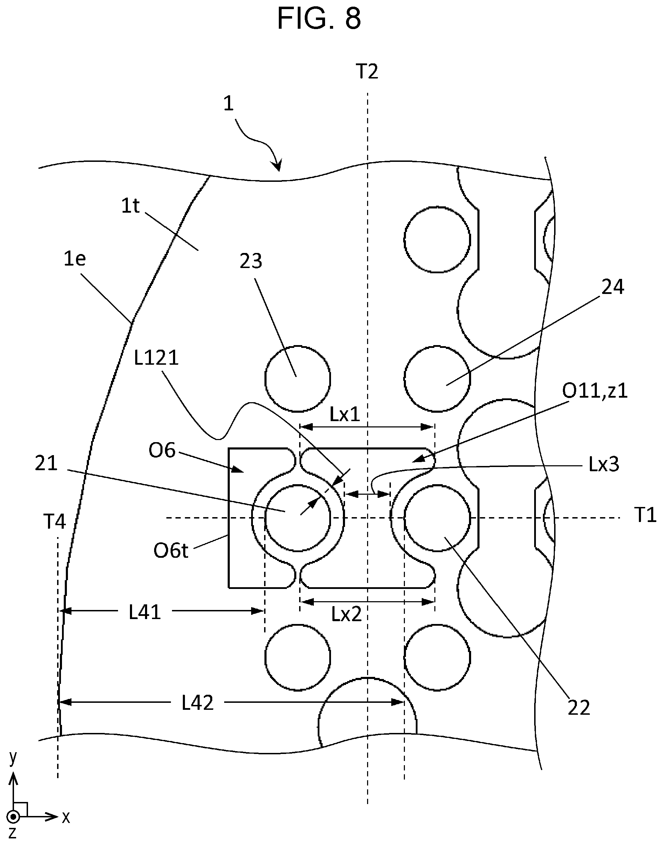

Description is made to the wiring board 101 according to the second embodiment with reference to FIG. 8.

In a planar view, the opening region z1 may be shaped to be along an outer edge of the first conductor 21 and may be shaped to be along an outer edge of the second conductor 22. In such a configuration, the opening region z1 (more specifically, the first portion O11) can be positioned close to the first conductor 21 and the second conductor 22 to be less likely to decrease the impedance value, whereas the first surface 1t can secure the region provided with the first conductor 21 and the second conductor 22. Being along herein means at least a portion being positioned to be spaced apart at a constant interval. For example, the first conductor 21 and the opening region z1 have only to have a constant distance L121 therebetween in an embodiment.

The substrate 1 may include an outer edge portion 1e in a circular shape in a planar view. In this case, a distance L41 between the first conductor 21 and the outer edge portion 1e is shorter than a distance L42 between the second conductor 22 and the outer edge portion 1e. That is, the first conductor 21 is positioned closer to the outer edge portion 1e in comparison to the second conductor 22. Herein, the distance L41 between the first conductor 21 and the outer edge portion 1e can be defined as the shortest distance in the x direction between a tangent T4 of the outer edge portion 1e at a certain point and the outer edge of the first conductor 21. The distance L42 between the second conductor 22 and the outer edge portion 1e can also be defined as described above.

The opening region z1 may further include a sixth opening O6 positioned to be spaced apart from the first conductor 21 and positioned between the outer edge portion 1e and the first conductor 21 in the x direction. The sixth opening O6 may have a linear shape O6t along the tangent T4 of the outer edge portion 1e in a planar view. The tangent T4 extends in the y direction in an embodiment. The tangent T4 is not necessarily a tangent of the outer edge portion 1e positioned closest to the first conductor 21. When the opening region z1 is positioned too close to the outer edge portion 1e, the substrate 1 may be damaged to be cracked or the like. The configuration as described above can keep the distance from the outer edge portion 1e as well as can increase in size of the sixth opening O6 as much as possible. Accordingly, the substrate 1 is less likely to decreased in strength whereas the conductor portion 2 is less likely to be decreased in impedance value.

### (Third Embodiment)

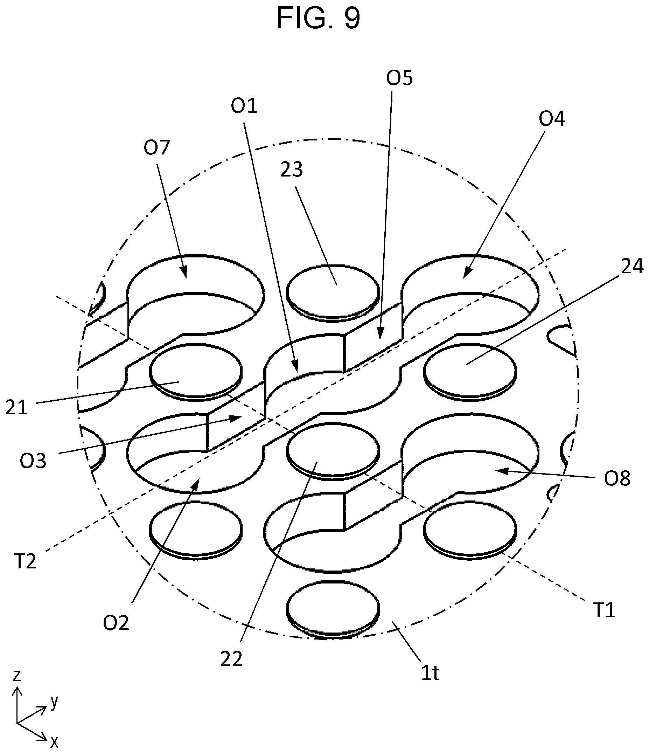

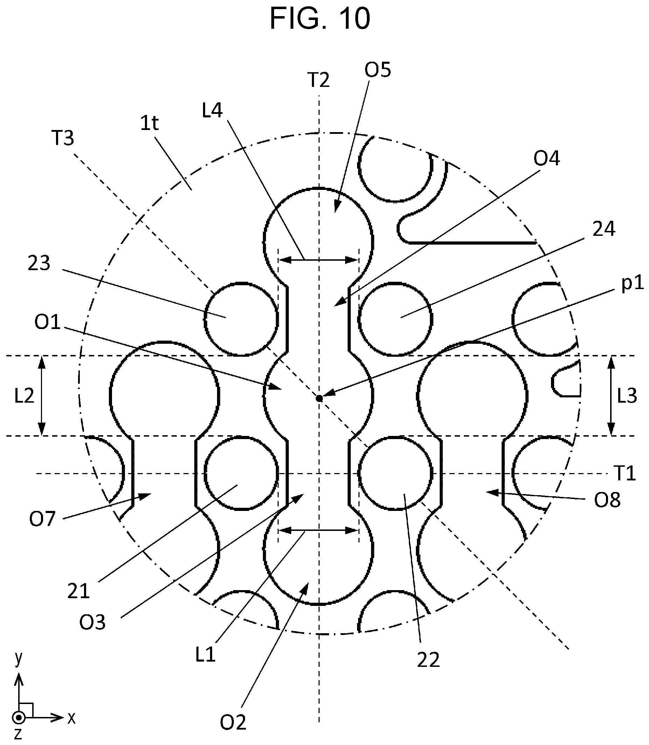

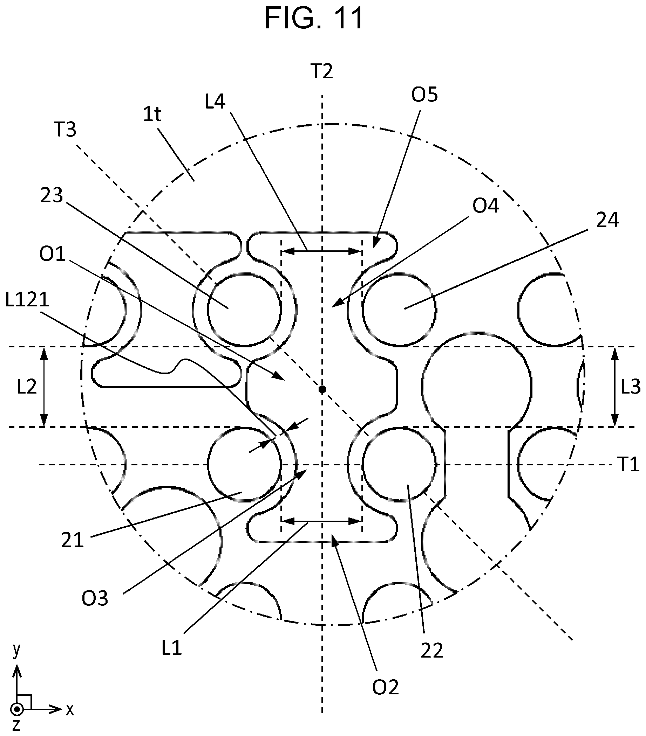

Description is made to the wiring board 101 according to the third embodiment with reference to FIGs. 9 to 11.

The conductor portion 2 may further include the third conductor 23 and the fourth conductor 24. At least one of the third conductor 23 or the fourth conductor 24 may be identical in material and shape to or different from at least one of the first conductor 21 or the second conductor 22. At least one of the third conductor 23 or the fourth conductor 24 may be electrically connected to at least one of the first conductor 21 or the second conductor 22 in the substrate 1. Each or only one of the third conductor 23 and the fourth conductor 24 may be a signal conductor.

The terminal portion 3 may further include a third pin terminal 33 and a fourth pin terminal 34. The third pin terminal 33 is electrically connected to the third conductor 23 and extends upward from the first surface 1t. The fourth pin terminal 34 is electrically connected to the fourth conductor 24 and extends upward from the first surface 1t. At least one of the third pin terminal 33 or the fourth pin terminal 34 may be identical in material and shape to or different from at least one of the first pin terminal 31 or the second pin terminal 32.

The third conductor 23 is positioned to be spaced apart from the first conductor 21 by a second distance L2 in the y direction. The fourth conductor 24 is positioned to be spaced apart from the second conductor 22 by a third distance L3 in the y direction. The third conductor 23 and the fourth conductor 24 are positioned to be spaced apart from each other by a fourth distance L4 in the x direction.

The second distance L2 may be equal to the third distance L3. The first distance L1 may be equal to the fourth distance L4. Furthermore, the first distance L1, the second distance L2, the third distance L3, and the fourth distance L4 may all be equal. That is, the first conductor 21, the second conductor 22, the third conductor 23, and the fourth conductor 24 may be aligned in a lattice shape on the first surface 1t. The first distance L1, the second distance L2, the third distance L3, and the fourth distance L4 may be 0.5 mm to 5 mm.

The first opening O1 is surrounded with the first conductor 21, the second conductor 22, the third conductor 23, and the fourth conductor 24. The first opening O1 may be equally distant from outer edges of the first conductor 21, the second conductor 22, and the third conductor 23, and the fourth conductor 24.

The opening region z1 may further include a fourth opening O4 and a fifth opening O5. The fourth opening O4 is positioned opposite to the second opening O2 with the first opening O1 interposed therebetween. The fifth opening O5 may be positioned between the third conductor 23 and the fourth conductor 24 on the second imaginary line T2, and may connect the first opening O1 and the fourth opening O4. That is, the opening region z1 (in other words, the first opening O1, the second opening O2, the third opening O3, the fourth opening O4, and the fifth opening O5) is configured as described above and thus extends at least from between the first conductor 21 and the second conductor 22 to between the third conductor 23 and the fourth conductor 24 in the y direction. The substrate 1 can thus be reduced in volume around the first conductor 21, the second conductor 22, the third conductor 23, and the fourth conductor 24. The conductor portion 2 is thus effectively less likely to be decreased in impedance value. Particularly when all the first conductor 21, the second conductor 22, the third conductor 23, and the fourth conductor 24 are signal conductors, the above configuration is less likely to decrease the impedance value to further enable radio-frequency signal transmission with a low loss. The opening region z1 can be formed once when the first opening O1, the second opening O2, the third opening O3, the fourth opening O4, and the fifth opening O5 are connected, to achieve a reduction in the number of times of piercing the substrate 1.

Assuming that a third imaginary line T3 passes through the second conductor 22 and the third conductor 23 and the second imaginary line T2 and the third imaginary line T3 cross each other at a first intersection point p1 in a planar view, the opening region z1 may be shaped symmetrically with respect to the first intersection point p1 in a planar view. Such a configuration facilitates equalizing the impedance values of the first conductor 21, the second conductor 22, the third conductor 23, and the fourth conductor 24.

### (Fourth Embodiment)

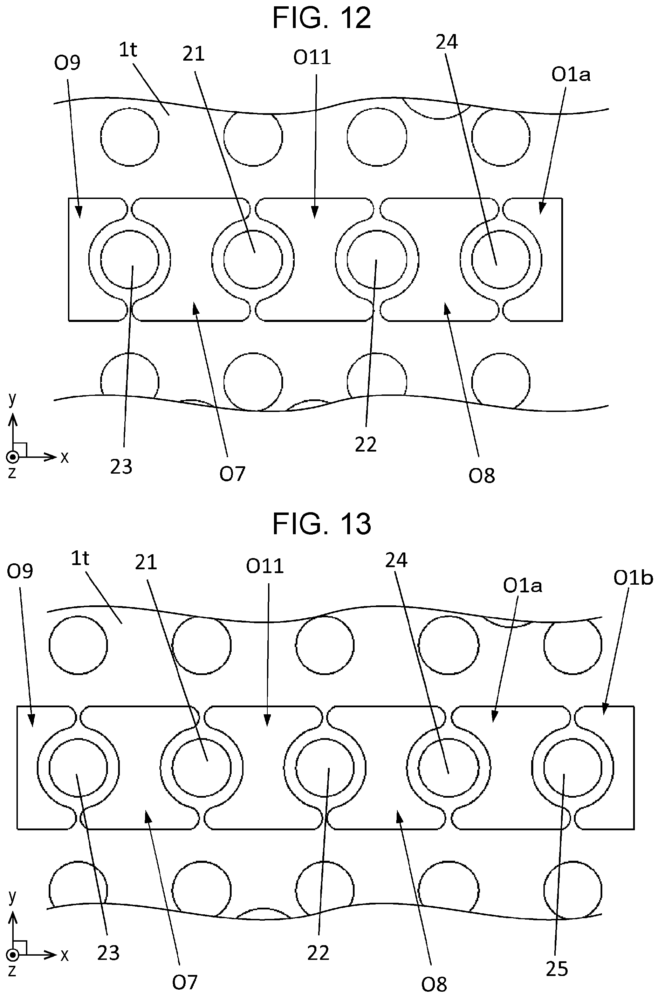

Description is made to the wiring board 101 according to the fourth embodiment with reference to FIG. 12.

In the fourth embodiment, the third conductor 23, the first conductor 21, the second conductor 22, and the fourth conductor 24 are aligned in the x direction in the mentioned order. In this case, the first conductor 21 and the second conductor 22 may be signal conductors whereas the third conductor 23 and the fourth conductor 24 may be ground conductors. The third conductor 23, the first conductor 21, the second conductor 22, and the fourth conductor 24 configure so-called GSSG wiring in this case.

The first conductor 21 and the third conductor 23 may interpose the seventh opening O7 in the x direction in this case. Furthermore, the second conductor 22 and the fourth conductor 24 may interpose the eighth opening O8 in the x direction.

In the fourth embodiment, the opening region z1 may include a ninth opening O9 and a tenth opening O1a. As illustrated in FIG. 12, the third conductor 23 may be positioned between the seventh opening O7 and the ninth opening O9 in the x direction in this case. Furthermore, the fourth conductor 24 may be positioned between the eighth opening O8 and the tenth opening O1a in the x direction.

The seventh opening O7 and the eighth opening O8 may be shaped symmetrically to each other in the x direction with respect to the first portion O11. The ninth opening O9 and the tenth opening O1a may be shaped line symmetrically to each other in the x direction with respect to the first portion O11.

### (Fifth Embodiment)

The conductor portion 2 may further include a fifth conductor 25.

Description is made to the wiring board 101 according to the fifth embodiment with reference to FIG. 13. Portions identical to corresponding portions according to the fourth embodiment will be denoted by identical reference signs and will not be described repeatedly in some cases.

In the fifth embodiment, the third conductor 23, the first conductor 21, the second conductor 22, the fourth conductor 24, and the fifth conductor 25 are aligned in the x direction in the mentioned order. In this case, the first conductor 21 and the fourth conductor 24 may be signal conductors whereas the third conductor 23, the fifth conductor 25, and the second conductor 22 may be ground conductors. The third conductor 23, the first conductor 21, the second conductor 22, the fourth conductor 24, and the fifth conductor 25 can also be described as configuring so-called GSGSG wiring in this case.

The opening region z1 may further include an eleventh opening O1b. As illustrated in FIG. 13, the fifth conductor 25 may be positioned between the tenth opening O1a and the eleventh opening O1b in the x direction in this case. Furthermore, the ninth opening O9 and the tenth opening O1a may be shaped line symmetrically to each other in the x direction with respect to the second conductor 22. Moreover, the seventh opening O7 and the tenth opening O1a may be shaped line symmetrically to each other in the x direction with respect to the second conductor 22.

### <Configuration of electronic component mounting substrate>

In an embodiment, an electronic component mounting substrate 10a includes the wiring board 101, and an electronic component connecting electrode 4 positioned on the second surface 1b opposite to the first surface 1t. The first conductor 21 and the second conductor 22 are electrically connected to the electronic component connecting electrode 4.

An electronic component 5 to be described later may be mounted directly on the electronic component connecting electrode 4, or may be mounted indirectly via a bonding wire, a lead terminal, or a flexible substrate. The terminal portion 3 and the conductor portion 2 are electrically connected to the electronic component 5 via the electronic component connecting electrode 4.

### <Configuration of electronic module>

In an embodiment, an electronic module 10 includes the electronic component mounting substrate 10a, and the electronic component 5 electrically connected to the electronic component connecting electrode 4.

The electronic component 5 may be configured to process a signal, e.g., convert a wireless signal or an optical signal to an electrical signal or convert an electrical signal to a wireless signal or an optical signal. The electronic component 5 may be bonded directly to the substrate 1, or may be positioned on the second surface 1b with a submount interposed therebetween. That is, the electronic component 5 may be bonded indirectly to the substrate 1.

Examples of the electronic component 5 include an optical semiconductor element such as a laser diode (LD) or a photodiode (PD), a semiconductor integrated circuit element such as a field effect transistor (FET), and a sensor element such as an optical sensor. The electronic component 5 can be made of a semiconductor material such as gallium arsenide or gallium nitride.

The electronic component 5 may be sealed by resin on the substrate 1. The electronic module 10 may be provided with a lid positioned to cover the substrate 1, and the electronic component 5 may be covered with the lid in this case. When the electronic component 5 is a light emitting element such as a laser diode, the lid may be provided with a light-transmissive member such as a lens.

The embodiments and variations may be combined variously without being limited to the embodiments exemplified above. Furthermore, combination is applicable among the embodiments, as well as among the variations.

### INDUSTRIAL APPLICABILITY

The present disclosure is applicable to a wiring board, an electronic component mounting substrate including the wiring board, and an electronic module.

### REFERENCE SIGNS

1 substrate
1t first surface
1b second surface
1e outer edge portion
2 conductor portion
21 first conductor
22 second conductor
23 third conductor
24 fourth conductor
25 fifth conductor
3 terminal portion
31 first pin terminal
311 pillar-shaped portion
312 seat portion
31b bonded surface
32 second pin terminal
33 third pin terminal
34 fourth pin terminal
T1 first imaginary line
T2 second imaginary line
T3 third imaginary line
T4 tangent
p1 first intersection point
z1 opening region
O11 first portion
O1 first opening
O2 second opening
O3 third opening
O4 fourth opening
O5 fifth opening
O6 sixth opening
O6t linear shape
O7 seventh opening
O8 eighth opening
O9 ninth opening
O1a tenth opening
O1b eleventh opening
D1 depth of opening region
L1 first distance
L2 second distance
L3 third distance
L4 fourth distance
L121 distance between first conductor and opening region
L41 distance between first conductor and outer edge portion
L42 distance between second conductor and outer edge portion
4A to 4B electronic component connecting electrode
5 electronic component
10 electronic module
10a electronic component mounting substrate
101 wiring board

## Claims

1. A wiring board comprising:
a substrate including a first surface and an opening region positioned in the first surface;
a conductor portion including a first conductor and a second conductor and positioned on the first surface; and
a terminal portion including a first pin terminal and a second pin terminal; wherein
the opening region includes a first opening,
the second conductor is positioned to be spaced apart from the first conductor in a first direction,
the first pin terminal is electrically connected to the first conductor and extends upward from the first surface,
the second pin terminal is electrically connected to the second conductor and extends upward from the first surface,
assuming that a first imaginary line extends in the first direction and passes through the first conductor and the second conductor and a second imaginary line extends in a second direction perpendicular to the first direction and passes through a midpoint in the first direction between the first conductor and the second conductor in a planar view,
the first opening is positioned to be spaced apart from the first conductor, the second conductor, and the first imaginary line in the second direction, and is positioned on the second imaginary line.

2. The wiring board according to claim 1, wherein
the opening region further includes a second opening, and
the second opening is positioned opposite to the first opening with the first imaginary line interposed therebetween.

3. The wiring board according to claim 1 or 2, wherein
the opening region further includes at least one third opening, and
the third opening is positioned between the first conductor and the second conductor on the first imaginary line.

4. The wiring board according to claim 3, wherein the third opening connects the first opening and the second opening in a planar view.

5. The wiring board according to claim 3 or 4, wherein the third opening has a size in the first direction on the first imaginary line, and the size is smaller than at least one of a maximum size in the first direction of the first opening or a maximum size in the first direction of the second opening.

6. The wiring board according to any one of claims 2 to 5, wherein the first opening and the second opening each have a circular shape in a planar view.

7. The wiring board according to any one of claims 3 to 5, wherein
the at least one third opening has a rectangular shape in a planar view, and
one of two opposing sides of the third opening is positioned along the second direction in a planar view.

8. The wiring board according to any one of claims 1 to 7, wherein in a planar view, the opening region is shaped to be along an outer edge of the first conductor and is shaped to be along an outer edge of the second conductor.

9. The wiring board according to any one of claims 1 to 8, wherein the opening region is shaped line symmetrically with respect to the first imaginary line in a planar view.

10. The wiring board according to any one of claims 1 to 9, wherein
the conductor portion further includes a third conductor and a fourth conductor,
the terminal portion further includes a third pin terminal and a fourth pin terminal,
the opening region further includes a fourth opening and a fifth opening,
a distance in the first direction between the second conductor and the first conductor is defined as a first distance,
the third conductor is positioned to be spaced apart from the first conductor by a second distance in the second direction,
the fourth conductor is positioned to be spaced apart from the second conductor by a third distance in the second direction,
the third conductor and the fourth conductor are positioned to be spaced apart from each other by a fourth distance in the first direction,
the third pin terminal is electrically connected to the third conductor and extends upward from the first surface,
the fourth pin terminal is electrically connected to the fourth conductor and extends upward from the first surface,
the second distance is equal to the third distance,
the first distance is equal to the fourth distance,
the first opening is surrounded with the first conductor, the second conductor, the third conductor, and the fourth conductor,
the fourth opening is positioned opposite to the second opening with the first opening interposed therebetween,
the fifth opening is positioned between the third conductor and the fourth conductor on the second imaginary line, and connects the first opening and the fourth opening.

11. The wiring board according to claim 10, wherein
assuming that a third imaginary line passes through the second conductor and the third conductor and the second imaginary line and the third imaginary line cross each other at a first intersection point in a planar view,
the opening region is shaped symmetrically with respect to the first intersection point in a planar view.

12. The wiring board according to any one of claims 1 to 11, wherein
the substrate includes an outer edge portion in a circular shape in a planar view,
a distance between the first conductor and the outer edge portion is shorter than a distance between the second conductor and the outer edge portion,
the opening region further includes a sixth opening positioned to be spaced apart from the first conductor and positioned between the outer edge portion and the first conductor in the first direction, and
the sixth opening has a linear shape along a tangent of the outer edge portion in a planar view.

13. The wiring board according to any one of claims 3, 4, 5, and 7, wherein
the opening region further includes a seventh opening positioned to be spaced apart from the first opening and the second opening,
the seventh opening is positioned on the first imaginary line, and
the first conductor is positioned between the seventh opening and the third opening in the first direction.

14. The wiring board according to any one of claims 3, 4, 5, 7, and 13, wherein
the opening region further includes an eighth opening positioned to be spaced apart from the first opening and the second opening,
the eighth opening is positioned on the first imaginary line, and
the second conductor is positioned between the eighth opening and the third opening in the first direction.

15. The wiring board according to any one of claims 1 to 14, wherein the opening region has a depth smaller than a distance between the first conductor and the second conductor in the first direction.

16. An electronic component mounting substrate comprising:
the wiring board according to any one of claims 1 to 15; and
an electronic component connecting electrode positioned on a second surface opposite to the first surface; wherein
the first conductor and the second conductor are electrically connected to the electronic component connecting electrode.

17. An electronic module comprising:
the electronic component mounting substrate according to claim 16; and
an electronic component electrically connected to the electronic component connecting electrode.
